Europäisches Patentamt

European Patent Office

Office européen des brevets

(19)

(11) Veröffentlichungsnummer: **0 276 509 B1**

(12) **EUROPÄISCHE PATENTSCHRIFT**

(45) Veröffentlichungstag der Patentschrift: **12.06.91**

(51) Int. Cl.⁵: **G01R 33/36**

(21) Anmeldenummer: **87202520.0**

(22) Anmeldetag: **15.12.87**

(54) **Kernresonanzgerät mit einschaltbarer Hf-Käfigspule.**

(30) Priorität: **22.12.86 NL 8603251**

(43) Veröffentlichungstag der Anmeldung:
**03.08.88 Patentblatt 88/31**

(45) Bekanntmachung des Hinweises auf die
Patenterteilung:
**12.06.91 Patentblatt 91/24**

(84) Benannte Vertragsstaaten:
**BE DE FR GB IT SE**

(56) Entgegenhaltungen:
EP-A- 0 170 558
DE-A- 3 427 666
GB-A- 2 050 062

JOURNAL OF MAGNETIC RESONANCE, Band
60, Nr. 3, Dezember 1984, Seiten 473-478,
Academic Press, Inc., New York, US; M.R.
BENDALL et al.: "Active detune switch for
complete sensitive-volume localization in in
vivo spectroscopy using multiple rf coils
and depth pulses"

RADIOLOGY, Band 157, Nr. 2, November
1985, Seiten 449-452, New York, US; E.B.
BOSKAMP: "Improved surface coil imaging
in MR: decoupling of the excitation and receiver coils"

(73) Patentinhaber: **N.V. Philips' Gloeilampenfabrieken
Groenewoudseweg 1
NL-5621 BA Eindhoven(NL)**

(72) Erfinder: **Mens, Wilhelmus Reinerius Maria
c/o INT. OCTROOIBUREAU B.V. Prof. Holstlaan 6
NL-5656 AA Eindhoven(NL)**

(74) Vertreter: **Faessen, Louis Marie Hubertus et al
INTERNATIONAAL OCTROOIBUREAU B.V. 6
Prof. Holstlaan
NL-5656 AA Eindhoven(NL)**

## Beschreibung

Die Erfindung betrifft ein Kernresonanzgerät mit einer im wesentlichen zylinderförmigen Hf-Resonanzspule, in der mit einer Anzahl axial über einen Zylindermantel verlaufender Stableiter eine im wesentlichen kosinusförmige Stromverteilung auf einem kreiszylindrischen Umfang erzeugbar ist.

Eine Hf-Spule für ein derartiges Kernresonanzgerät ist aus der US-A-4 339 718 bekannt und basiert auf der schon lange bekannten Erkenntnis, dass für eine homogene Feldverteilung in einer derartigen Spule eine kosinusförmige Stromerteilung auf den Umfang der zylinderförmigen Spule erforderlich ist. Derartige Spulen werden auch als Käfigspulen bezeichnet, und stehen in derartigen Kernresonanzgeräten in mehreren Ausführungen zur Verfügung. In einer Ausführungsform dient die Käfigspule zum Erzeugen und Detektieren eines Hf-Feldes zum Erzeugen und Messen von Kernresonanzsignalen in einem Körperteil eines Patienten. Eine derartige Spule wird im weiteren mit Körperspule bezeichnet. Die einer derartigen Körperspule gestellten Anforderungen bestehen in der Erzeugung eines Hf-Feldes in nur einer Richtung und in der Abgabe einer hohen Leistung. Weiter werden diese Spulen vom Sender auf den Empfänger umgeschaltet, und dieses Umschalten soll schnell erfolgen.

In einem anderen Ausführungsbeispiel arbeitet die Käfigspule mit einer Oberflächenspule zusammen, die direkt auf einem Patienten angesetzt ist. Eine derartige Oberflächenspule kann in verschiedenen Orientierungen angeordnet werden, ist in wenigstens einer Richtung Hf-empfindlich, braucht nur ein niedriges Signal abzugeben, und muss oft und rasch vom Abschalt- in den Empfangszustand umgeschaltet werden. Dieser Umschaltvorgang liegt in der Grössenordnung von 1 Millisekunde. Wird die Körperspule abgeschaltet (nach dem Erregen), wird die Oberflächenspule eingeschaltet und umgekehrt. Eine letzte und die wichtigste Anforderung, die in Käfigspulen gestellt wird, besteht darin, dass sie schnell ausschaltbar sind, damit sie die Wirkung anderer Spulen (beispielsweise der Oberflächenspule) nicht stören. Ein weiteres Beispiel einer Hf-Käfigspule ist aus EP-A-170558 bekannt.

Der Erfindung liegt die Aufgabe zugrunde, ein Kernresonanzgerät mit einer Hf-Käfigspule zu schaffen, in der die genannte Anforderung erfüllt ist.

Zur Lösung dieser Aufgabe ist das eingangs erwähnte Kernresonanzgerät erfindungsgemäss dadurch gekennzeichnet, dass zum Abschalten der Hf-Spule wenigstens eine Anzahl der Stableiter mit Schaltmitteln zum Unterbrechen des leitenden Zustands in den Stableitern vorgesehen sind. Durch die Unterbrechung des leitenden Zustands in weinigstens einer Anzahl von Stableitern muss die für die Spule geltende Umlaufbedingung derart gestört werden, dass ein Resonanzkreis, von dem die Spule ein Teil ist, nicht mehr oder auf einer stark abweichenden Frequenz schwingt. Die hier genannte Umlaufbedingung ist im einzeln in der früheren und noch nicht veröffentlichten niederländischen Patentanmeldung 8502273 (PHN 11 466) beschrieben.

Ein Ausführungsbeispiel eines Kernresonanzgeräts nach der Erfindung ist dadurch gekennzeichnet, dass die im Betrieb der Spule den meisten Strom führenden Stableiter zu ihrer Verstimmung unterbrochen werden, wobei die unterbrochenen Stableiter in nur einer Symmetriehälfte der Spule liegen.

Ein bevorzugtes Ausführungsbeispiel eines erfindungsgemässen Kernresonanzgeräts ist dadurch gekennzeichnet, dass die Schaltmittel nahezu halbwegs der Stableiter angeordnet sind. Die Unterbrechung der Längsleiter nahezu in ihrer Mitte bietet den Vorteil, dass über die Schaltmittel nahezu keine Hf-Spannungsunterschiede auftreten. Der Vorteil dabei ist, dass zum Betreiben der Schaltmittel Niederspannungskreise verwendbar sind.

Ein weiteres Ausführungsbeispiel eines erfindungsgemässen Kernresonanzgeräts ist dadurch gekennzeichnet, dass die Schaltmittel PIN-Dioden sind.

Ausführungsbeispiele der Erfindung werden nachstehend an Hand der Zeichnung näher erläutert. Es zeigen:

Fig. 1 ein erfindungsgemässes Kernresonanzgerät.

Fig. 2 ein Ausführungsbeispiel einer erfindungsgemässen Käfigspule,

Fig. 3 ein elektrisches Ersatzschaltbild der abschaltbaren Hf-Spule nach Fig. 2, und

Fig. 4 ein elektrisches Ersatzschaltbild einer weiteren abschaltbaren Spule, und

Fig. 5 ein elektrisches Schaltbild des Elektronikschalters.

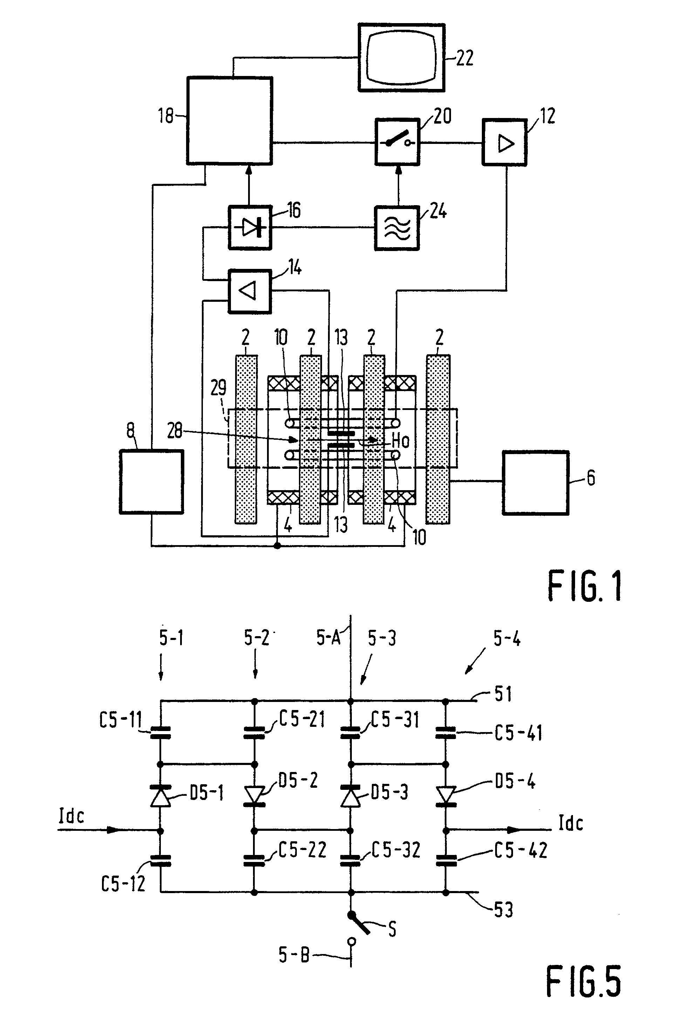

Ein Kernspinresonanzgerät nach Fig. 1 enthält ein Magnetsystem 2 zum Erzeugen eines statischen Magnetfeldes HO, ein Magnetsystem 4 zum Erzeugen magnetischer Gradientenfelder und Speisequellen 6 bzw. 8 für das Magnetsystem 2 bzw. das Magnetsystem 4. Eine Hf- Magnetspule 10 dient zum Erzeugen eines Hf- Magnetfeldes und ist an einer Hf-Quelle 12 angeschlossen. Für die Detektion der vom Hf-Sendefeld in einem zu unterchenden Objekt erzeugten Kernspinresonanzsignale wird eine Oberflächenspule 13 benutzt, und diese ist dazu mit einem Signalverstärker 14 verbunden. Der Signalverstärker 14 ist an einen phasenempfindlichen Gleichrichter 16 angeschlossen, der mit einer zentralen Steueranordnung 18 verbunden ist. Die zentrale Steueranordnung 18 steuert weiter einen Modulator 20 für die Hf-Quelle 12, die Speisequelle 8 für die Gradientenspulen und einen Monitor 22 für die Bildwiedergabe. Ein Hochfrequenzoszillator 24 speist sowohl den Modulator 20 als auch den Messignale verarbeiten den phasenempfindlichen Gleichrichter 16. Die in den Magnetsystemen 2 und 4 angeordnete Sendespule 10 schliesst einen Messraum 28 ein, der bei einem Gerät für medizinischdiagnostische Messungen gross genug ist zum Aufnehmen eines zu untersuchenden Patienten. Im Messraum 28 müssen also ein statisches Magnetfeld HO, Objektschnitte festlegende Gradientenfelder und ein räumlich homogenes Hf-Wechselfeld erzeugt werden. Die HF-Spule 10 kann die Funktionen der Sendespule und der Messspule kombinieren. Für beide Funktionen wird hier jedoch mit verschiedenen Spulen gearbeitet, beispielsweise mit der Oberflächenspule 13 als Messspule. In diesem Fall wird die Hf-Spule 10 schnell abgeschaltet und die Oberflächenspule 13 muss schnell eingeschaltet werden. Die Hf-Spule 10 muss abgeschaltet werden, damit sie die Detektion nicht stört. Die Oberflächenspule 13 muss schnell eingeschaltet werden, weil so möglichst wenig von den erzeugtenHf-Signalen verloren geht.

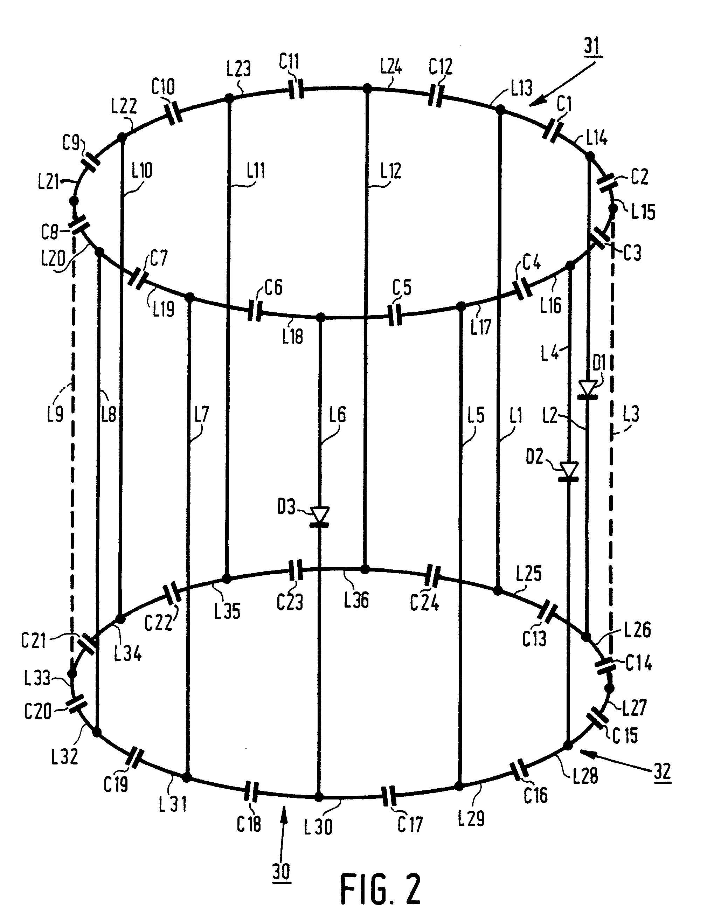

In Fig. 2 ist schematisch ein Ausführungsbeispiel einer erfindungsgemässen Käfigspule 30 dargestellt. Die dargestellte Spule 30 enthält zwei Ringleiter 31 und 32, zwischen denen Stableiter angeordnet sind. Die Stableiter sind auf einem Kreismantel des von der Spule eingeschlossenen zylinderförmigen Raums angeordnet. Im ausgewählten Beispiel ist für jeden Teil des Ringleiters zwischen zwei Stableitern das Ersatzschaltbild einer Kapazität und einer Selbstinduktivität in Reihenschaltung genommen. Die Stableiter bilden eine Selbstinduktivität und sind von L1 bis L12 numeriert. Wenn für eine gegebene bzw. gewünschte Frequenz die Stableiter L1 bis L12 als Selbstinduktivität in der Schaltung wirken, bedingt eine gegebene Resonanzbedingung dass die Ringleiterelemente zwischen jedem Stab - leiterpaar eine reaktive Funktion erfüllen sollen. Da die Stromverteilung auf den Umfang kosinusförmig ist, führen zwei Stromleiter L3 und L9 keinen Strom und sie können daher ausgelassen werden (L3 und L9 sind deswegen punktiert dargestellt). Als reaktive Elemente sind in einem ersten Ringleiter 31 Kapazitäten mit der Numerierung C1 bis C12 und für den Ringleiter 32 Kapazitäten mit der Numerierung C13 bis C24 angegeben. Weiter besitzen die Ringleiter eine induktive Impedanz, die hier mit den Selbstinduktivitäten L13 bis L24 für den ersten Ringleiter und L25 bis L36 für den zweiten Ringleiter angegeben ist. Die Werte für die Kapazitäten C1 bis C24 und die Selbstinduktivitäten L13 bis L36 sind im wesentlichen gleich.

Erfindungsgemäss sind einige Stableiter L2, L4 und L6 mit Schaltmitteln D1, D2 und D3 versehen, die die Stableiter unterbrechen, wenn die dargestellte Hf-Spule abgeschaltet werden muss. Welche der Stableiter unterbrochen werden ist von der Verwendung der Spule abhängig. Jedoch kann allgemein unterstellt werden, dass in einem bevorzugten Ausführungsbeispiel die Stableiter, die in einer Symmetriehälfte der Spule den grössten Strom führen, unterbrochen werden. Obgleich dies eine klare Abweichung vom Idealfall ist, indem alle Stableiter unterbrochen sind, wurde dies für die Praxis als optimale Lösung gefunden.

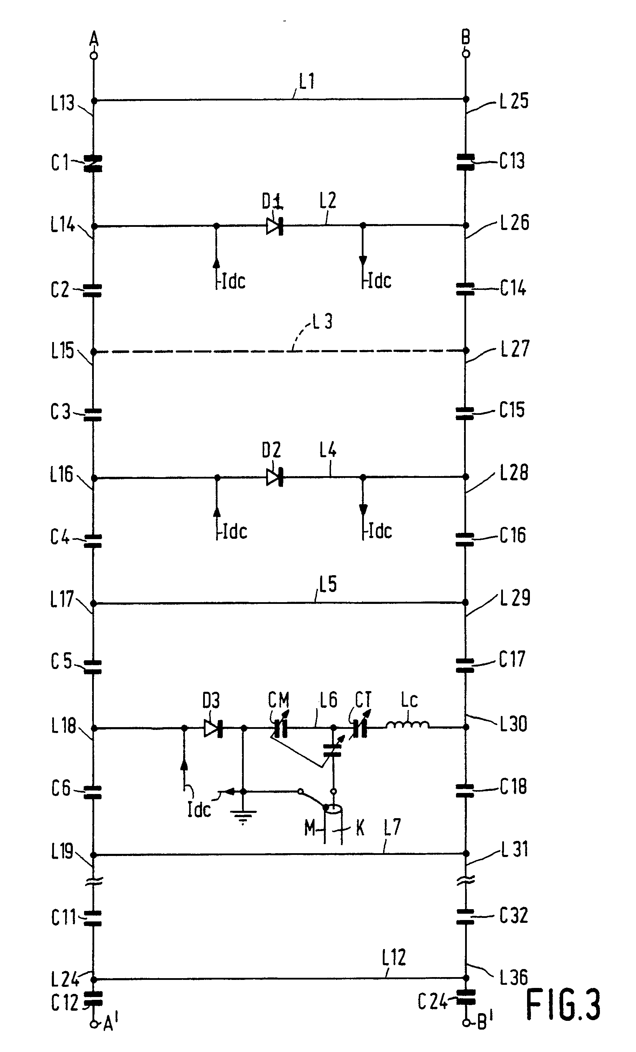

In Fig. 3 ist ein elektrisches Ersatzschaltbild eines Ausführungsbeispiels einer 64-MHz-Käfigspule gegeben. Nur ein Teil der Spule nach Fig. 2 ist dargestellt, wobei die der Fig. 2 entsprechenden Teile mit gleichen Bezugsziffern bezeichnet sind. Es sei bemerkt, dass die Punkte A und B mit den Punkten A' bzw. B' kurzgeschlossen werden müssen, um die zylindrische Spulenform nach Fig. 2 elektrisch nachzubilden. Zum Abschalten der Spule 30 sind in den Stableitern L2, L4 und L6 PIN-Diodenschalter D1, D2, D3 angebracht, die bei abgeschalteter Spule ein Vorwärts strom Idc durchfliesst. Die Diodenschalter D1, D2 und D3 werden weiter unten näher erläutert.

Die Hf-Energie für die in Fig. 3 dargestellte Spule wird über ein Koaxkabel K zugeleitet, das über eine Anpassungskapazität CM an der Leiter L6 angeschlossen ist. Mit einer Abstimmkapazität CT ist eine gewünschte Resonanzfrequenz einstellbar- Zum Ausgleichen einer kapazitiven Impedanz, die durch die Abstimm- und Anpasskapazitäten CT und CM entsteht, ist in Reihe damit eine Ausgleichspule Lc angebracht, so dass der Leiter L6 und die daran angeschlossenen Bauteile insgesamt wieder die gleiche Impedanz bilden, wie die Leiter L1, L2, L4, L5, usw.

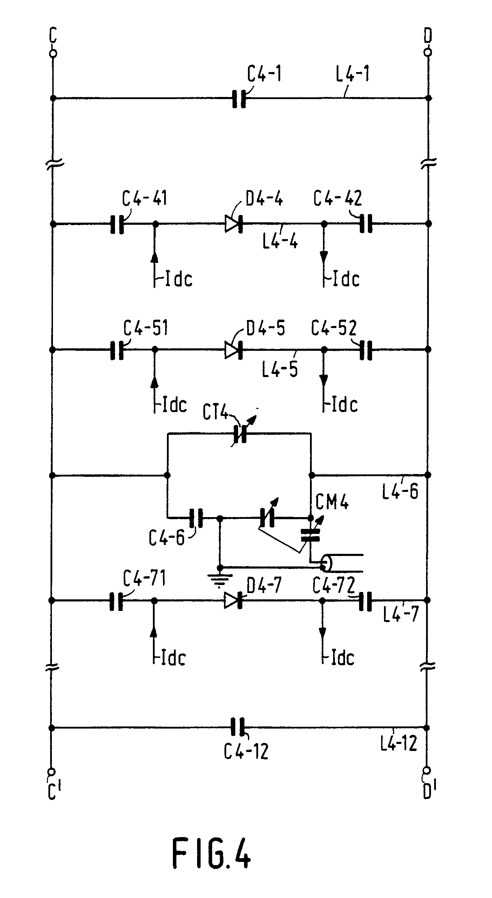

In Fig. 4 ist ein anderes Ausführungsbeispiel einer erfindungsgemässen Käfigspule dargestellt. Hierbei ist in Reihe mit den Stableitern L4-1, L4-12 eine Kapazität C4-1, C4-12 geschaltet, die vorzugsweise in der Mitte der Stableiter L4-1, L4-12 angeordnet ist (auch in diesem Ausführungsbeispiel sind die Leiter L4-3 und L4-9 nicht vorhanden). Die Leiter L4-2, L4-8, L4-10 und L4-11 sind genau so ausgeführt wie L4-12, sie sind aber in der Fig. 4 nicht dargestellt. Falls der Wert der Kapazität C4-1 50 pF beträgt, sind in den Leitern L4-4, L4-5, und L4-7 immer zwei Kapazitäten C4-41 und C4-42, C4-51 und C4-52 und C4-71 und C4-72 in Reihe mit einem Halbleiterdiodenschalter D4-4, D4-5 und D4-7 geschaltet. Die Diodenschalter D4-4, D4-5 und D4-7 werden mittels eines Stromdurchgangs aktiviert, so dass die Reihenschaltung der Leiter L4-4, L4-5 und L4-7 und die Kapazitäten C4-41 und C4-42, C4-51 und C4-52, C4-71 und C4-72 unterbrochen wird. Es sei bemerkt, dass, da in den Leitern L4-4, L4-5 und L4-7 stets zwei Kapazitäten in Reihe geschaltet sind, diese Kapazitäten je einen Wert von 100 pF haben sollen. In den Leiter L4-6 wird die Hf-Leistung über ein Koaxkabel K4 und eine Anpassungskapazität CM4 eingeführt. Die Kapazität CM4 ist der Symmetrie wegen mit einer nahezu gleich grossen Kapazität C4-6 in Reihe geschaltet. Den Kapazitäten CM4 und C4-6 ist eine Abstimmkapazität CT4 zum Einstellen der gewünschten Resonanzfrequenz parallel geschaltet (die Abstimmkapazität hat beispielsweise einen Wert von 30 pF und die Kapazität C4-6 hat dabei den Wert 40 pF, genau so wie die beiden Teile der Anpassungskapazität CM-4). Ausserdem sei hier noch erwähnt, dass im elektrischen Schaltbild der Käfigspule nach Fig. 4 die Enden C bzw. D mit den Enden C' bzw. D' kurzgeschlossen werden müssen.

In Fig. 5 ist ein Ausführungsbeispiel eines Diodenschalters dargestellt, der in die Spulen nach Fig. 3 und 4 einsetzbar ist. Der Schalter enthält zwischen zwei Leitern 51 und 53 parallel geschaltete Zweige 5-1, 5-2, 5-3 und 5-4, die je eine Reihenschaltung aus einer ersten Kapazität, einer PIN-Diode und einer zweiten Kapazität enthalten. Die Leiter 51 und 53 werden mit den Enden 5-A und 5-B in einem der in Fig. 3 oder 4 dargestellten Leitern verbunden. Der Strom Idc, der den Schalter "öffnen" muss, wird im ersten Zweig 5-1 zwischen der Kapazität C5-12 und der Diode D5-1 zugeführt. Die Kathode der Diode D5-i im Abzweig 5-i ist mit der Anode der Diode D5-(i+1) verbunden, so dass sie für einen Gleichstrom zum Ein- und Abschalten in Reihe geschaltet sind. Die dargestellte Konfiguration bietet den Vorteil, dass bei einer Anordnung des Schalters in der Mitte der Leiter (siehe beispielsweise Fig. 2) durch die Hf-Signalspannungen in der Spule und durch den Hf-Spannungsverlauf über einen derartigen Stableiter, der in der Mitte des Leiters einen Nulldurchgang besitzt, der Diodenschalter mit Niederspannung betreibbar ist und keine Hf-Drosseln verwendet zu werden brauchen. Weiter sei bemerkt, dass bei geschlossenem Schalter die PIN-Dioden D5-1, D5-2, D5-3 und D5-4 für die Hf-Signalströme parallel geschaltet sind. Die Kapazitätswerte der Kapazitäten C5-11, C5-12, C5-21 ... C5-42 sind so gross gewählt, dass sie für die Resonanzfrequenz der Käfigspule eine vernachlässigbare Impedanz bilden.

Weiter ist es möglich in Reihe mit dem Halbleiterdiodenschalter einen elektromechanischen Schalter S aufzunehmen, der in bezug auf den Halbleiterschalter verhältnismässig träge ist, aber schon einen höheren Spannungsabfall über die geöffneten Kontakte aushalten kann.

Mehrere Abwandlungen des Halbleiterschalters sind möglich, so könnten zum Herabsetzen der Reihenimpedanz noch einige Abzweige zwischen den Schaltern 51 und 53 angeordnet werden (dabei haben immer die Abzweige mit einem ungeraden Index die gleichen Bauteile und dieselbe Orientierung, genau so gilt dies für die Abzweige mit einem geraden Index). Auch könnten zum Beschränken der Anzahl von Bauteilen die Abzweige 5-3 und 5-4 ausgelassen werden.

Eine andere Bauteileinsparung ist durch Auslassen der Kapazitäten L5-11 und L5-41, durch den Ersatz sowohl der Kapazitäten C5-12 und C5-22 als auch der Kapazitäten C5-32 und C5-42 durch eine Kapazität sowohl zwischen der Anode der Diode D5-1 und der Kathode der Diode D5-2 als auch zwischen der Anode der Diode D5-3 und Diode D5-4, und durch direktes Anschliessen des Schalters S an die Dioden D5-2 und D5-3 erreichbar.

## Ansprüche

1. Kernresonanzgerät mit einer im wesentlichen zylinderförmigen Hf Resonanzspule, in der mit einer Anzahl axial über einen Zylindermantel verlaufender Stableiter eine im wesentlichen kosinusförmige Stromverteilung auf einen kreiszylindrischen Umfang erzeugbar ist, dadurch gekennzeichnet, dass zum Abschalten der Hf-Spule wenigstens eine Anzahl der Stableiter mit Schaltmitteln zum Unterbrechen des leitenden Zustands in den Stableitern vorgesehen sind.

2. Kernresonanzgerät nach Anspruch 1, dadurch gekennzeichnet, dass die Stableiter, die bei Resonanz den grössten Strom führen, zum Abschalten unterbrochen werden, wobei die unterbrochenen Stableiter sich in nur einer Symmetriehälfte der Spule befinden.

3. Kernresonanzgerät nach Anspruch 1, dadurch gekennzeichnet, dass die Schaltmittel elektronische Schaltmittel sind.

4. Kernresonanzgerät nach einem der vorangehenden Ansprüche, dadurch gekennzeichnet, dass die Schaltmittel nahezu in der Mitte der Stableiter angeordnet sind.

5. Kernresonanzgerät nach einem der vorangehenden Ansprüche, dadurch gekennzeichnet, dass die Schaltmittel PIN-Diodenschalter sind.

6. Kernresonanzgerät nach Anspruch 5, dadurch gekennzeichnet, dass elektromechanische Schalter mit den PIN-Diodenschaltern in Reihe geschaltet sind.

7. Kernresonanzgerät nach Anspruch 5 oder 6, dadurch gekennzeichnet, dass der PIN-Diodenschalter eine Hf-Parallelschaltung und eine Gleichspannungsreihenschaltung aus wenigstens zwei PIN-Dioden ist.

8. Kernresonanzgerät nach Anspruch 5, dadurch gekennzeichnet, dass die Schaltmittel eine Anzahl parallel geschalteter Abzweige mit je einer Reihenschaltung aus einer ersten Kapazität, einer PIN-Diode und einer zweiten Kapazität sind, wobei in die Abzweige mit einem ungeraden Index die PIN-Diode in entgegengesetztem Sinn in bezug auf die PIN-Diode in den Abzweigen mit einem geraden Index eingeschaltet ist, wobei einer Anode einer PIN-Diode im ersten Abzweig ein Strom zuleitbar ist, der über die Kathode der PIN-Diode im Abzweig mit dem höchsten Index ableitbar ist, wobei stets die Kathode der Diode in einem Abzweig mit dem Index i mit der Anode der PIN-Diode im Abzweig mit dem Index i + 1 verbunden ist, wobei von den PIN-Dioden abgewandte Seiten der Kapazitäten des Schalters Anschlusspunkte für die Stableiter der Spule bilden.

## Claims

1. A magnetic resonance imaging apparatus, comprising a substantially cylindrical RF resonance coil in which a substantially cosinusoidal current distribution can be generated across a circular-cylindrical circumference by means of a number of rod conductors which extend axially across a cylindrical surface, characterized in that for the deactivation of the RF coil at least a number of the rod conductors are provided with switching means for interrupting the conductance in the rod conductors.

2. A magnetic resonance imaging apparatus as claimed in Claim 1, characterized in that the rod conductors which carry most current in the case of resonance are interrupted for deactivation, the interrupted rod conductors being situated in one symmetry half of the coil.

3. A magnetic resonance imaging apparatus as claimed in Claim 1, characterized in that the switching means are electronic switching means.

4. A magnetic resonance imaging apparatus as claimed in any one of the preceding Claims, characterized in that the switching means are arranged substantially halfway the rod conductors.

5. A magnetic resonance imaging apparatus as claimed in any one of the preceding Claims, characterized in that the switching means are PIN diode switches.

6. A magnetic resonance imaging apparatus as claimed in Claim 5, characterized in that electromechanical switches are connected in series with the PIN diode switches.

7. A magnetic resonance imaging apparatus as claimed in Claim 5 or 6, characterized in that the PIN diode switch is an RF parallel connection and a DC series connection of at lest two PIN diodes.

8. A magnetic resonance imaging apparatus as claimed in Claim 5, characterized in that the switching means comprise a number of parallel connected branches, each of which comprises a series connection of a first capacitance, a PIN diode and a second capacitance, the PIN diode in the branches having an odd index being activated in the opposite sense with respect to the PIN diode in the branches having an even index, it being possible to apply a current to an anode of a PIN diode in the first branch which can be output via the cathode of the PIN diode in the branch having the highest index, the cathode of the diode in a branch having the index i always being connected to the anode of the PIN diode in the branch having the index i + 1, the ends of the capacitances of the switch which are remote from the PIN diodes forming connection points for the rod conductors of the coil.

## Revendications

1. Appareil de résonance magnétique nucléaire comportant une bobine de résonance Hf principalement cylindrique, dans laquelle une répartition de courant principalement cosinusoïdale peut être obtenue sur une périphérie cylindrique circulaire à l'aide d'un certain nombre de barreaux conducteurs s'étendant axialement sur une enveloppe cylindrique, caractérisé en ce que, pour le déclenchement de la bobine Hf, au moins certains des barreaux conducteurs sont pourvus de moyens de commutation permettant d'y interrompre l'état conducteur.

2. Appareil de résonance magnétique nucléaire suivant la revendication 1, caractérisé en ce que les barreaux conducteurs, dans lesquels passe le plus de courant en cas de résonance, sont interrompus en vue du déclenchement, les barreaux conducteurs interrompus ne se trouvant que dans une seule moitié symétrique de la bobine.

3. Appareil de résonance magnétique nucléaire suivant la revendication 1, caractérisé en ce que les moyens de commutation sont des moyens de commutation électroniques.

4. Appareil de résonance magnétique nucléaire suivant l'une quelconque des revendications précédentes, caractérisé en ce que les moyens de commutation sont disposés à peu près au milieu des barreaux conducteurs.

5. Appareil de résonance magnétique nucléaire suivant l'une quelconque des revendications précédentes, caractérisé en ce que les moyens de commutation sont des commutateurs à diodes PIN.

6. Appareil de résonance magnétique nucléaire suivant la revendication 5, caractérisé en ce que des commutateurs électromécaniques sont montés en série avec les commutateurs à diodes PIN.

7. Appareil de résonance magnétique nucléaire suivant la revendication 5 ou 6, caractérisé en ce que le commutateur à diodes PIN est un montage en parallèle Hf et un montage en série en courant continu d'au moins deux diodes PIN.

8. Appareil de résonance magnétique nucléaire suivant la revendication 5, caractérisé en ce que les moyens de commutation sont constitués par un certain nombre de branches connectées en parallèle qui comportent chacune un montage en série d'un premier condensateur, d'une diode PIN et d'un second condensateur, où dans les branches de numéro impair, la diode PIN est connectée dans le sens opposé à celui dans lequel la diode PIN est connectée dans les branches de numéro pair où une anode d'une diode PIN dans la première branche peut recevoir un courant qui peut être prélevé par l'intermédiaire de la cathode de la diode PIN présente dans le branchement du numéro le plus élevé, où la cathode de la diode d'une branche de numéro i est chaque fois connectée à l'anode de la diode PIN de la branche de numéro i + 1 et où les bornes des condensateurs du commutateur qui sont éloignées des diodes PIN constituent des points de connexion pour les barreaux conducteurs de la bobine.

FIG.1

FIG.5

FIG. 2

FIG.3

FIG.4